# EUROPEAN PATENT APPLICATION

(11) **EP 4 580 322 A1**
(43) Date of publication of application: **02.07.2025**
(21) Application number: 24222967.2
(22) Date of filing: 23.12.2024
(51) Int. Cl.: H05K 5/06

(54) **APPARATUS AND METHOD FOR SEALED HOUSING**

(30) Priority: 27.12.2023 US 202363614980 P
(71) Applicant: Solaredge Technologies Ltd., Herzeliya 4673335 (IL)
(72) Inventor: KEREN, Yuval, 4673335 Herzeliya (IL); DININ, Leonid, 4673335 Herzeliya (IL); GOMBERG, Bryon Roos, 4673335 Herzeliya (IL)
(74) Representative: V.O.

(57) **Abstract**

Disclosed is an apparatus comprising a housing comprising an opening; at least one seal; and a cover. The apparatus has a closed configuration and an open configuration, wherein in the closed configuration, the cover fills the opening, and in the open configuration the cover and the housing are separated. The cover may be moved from the closed configuration to the open configuration along a first direction and from the open configuration to the closed configuration along a second direction. At least one seal retention structure is provided on the cover and/or the housing, comprising a seal recess, wherein the seal recess is configured to retain the seal; at least one sealing surface is provided around an edge of the opening of the housing and/or the cover, wherein the at least one sealing surface is configured to abut at least a portion of the at least one seal. The cover comprises a first hook. The apparatus further comprises a second hook configured to engage the first hook thereby limiting motion of the cover in the first direction in the closed configuration and a rotating element comprising an axis of rotation and a cover lift cam configured to apply a force to the cover in the first direction, based on the rotating element being rotated, causing the cover to separate from the housing. Further disclosed is a method for sealing and/or opening a housing.

## Description

### BACKGROUND

Housings may be used to protect objects inside the housing from elements that are outside the housing (e.g., liquids, dust, etc.). Housings may be used to house devices, such as electronic devices. Housings may be sealed to increase the protection of the objects enclosed inside the housing. Housings may be unsealed to access the objects enclosed inside the housing.

### SUMMARY

The claimed invention proposes an apparatus comprising: a housing comprising an opening; at least one seal; and a cover; wherein the apparatus has a closed configuration and an open configuration, wherein in the closed configuration, the cover fills the opening, and in the open configuration the cover and the housing are separated, wherein the cover may be moved from the closed configuration to the open configuration along a first direction and from the open configuration to the closed configuration along a second direction; wherein: at least one seal retention structure is provided on the cover and/or the housing, comprising a seal recess, wherein the seal recess is configured to retain the seal; at least one sealing surface is provided around an edge of the opening of the housing and/or the cover, wherein the at least one sealing surface is configured to abut at least a portion of the at least one seal, and wherein the cover comprises a first hook; the apparatus further comprising: a second hook configured to engage the first hook thereby limiting motion of the cover in the first direction in the closed configuration; a rotating element comprising an axis of rotation and a cover lift cam configured to apply a force to the cover in the first direction, based on the rotating element being rotated, causing the cover to separate from the housing.

The housing may further comprise cover guides, wherein in the closed configuration: the sealing surface and the cover guides are configured to compress the seal and the seal retention structure, in particular to form an ingress protection rated closure, and the cover guides are configured to constrain a movement of the seal retention structure in a lateral direction.

The cover guides may comprise angled surfaces configured to push the seal retention structure toward the sealing surface based on the apparatus changing from the open configuration to the closed configuration.

The rotating element may comprise a mechanical element and wherein in the closed configuration the mechanical element is configured to separate the first hook from the second hook based on the rotating element being rotated.

The seal recess may be configured to apply a first force to the seal substantially opposite the first direction based on a transition from the open configuration to the closed configuration, and wherein the seal recess is configured to apply a second force to the seal in substantially the second direction based on a transition from the closed configuration to the open configuration.

The rotating element may be configured to rotate in an opening orientation to change the apparatus from the closed configuration to the open configuration, wherein the rotating element comprises a biasing means, in particular a return spring or a cantilever, configured to apply a rotational force to the rotating element, where the rotational force is directed against the opening orientation.

The rotating element may comprise a tool recess configured to accept a tool, wherein the tool recess comprises a shape that is configured to apply torque to the rotating element based on the tool being rotated.

The second hook may be incorporated into the rotating element.

The second hook may comprise a cantilever and is incorporated into the housing, and wherein the rotating element comprises a release cam configured to: apply a second force to the cantilever, deflect the cantilever and release the second hook from the first hook.

The rotating element may be accessible from a hole in the cover, and wherein the axis of rotation of the rotating element is substantially parallel to the first direction.

The rotating element may be accessible from a hole in the housing, and wherein the axis of rotation of the rotating element is substantially perpendicular to the first direction.

The apparatus may further comprise a second seal recess and a second seal between the rotating element and a hole in the cover or a hole in the housing which preferably form an ingress protection rated closure.

The rotating element may comprise a first part, a second part, and a fastener, and the first part is connected to the second part using the fastener, in particular one or more of a spring clip, a screw, a bolt, a nail, and a rivet.

The rotating element may further comprise rotation guides.

There is further disclosed a method for sealing and/or opening a housing, comprising: for sealing the housing with a cover to form an enclosure: pressing the cover onto an opening of the housing, and: forcing a seal, disposed in a recess of a seal retention structure of the cover, against a sealing surface of the housing via cover guides that press the seal retention structure and the seal towards the sealing surface; and engaging a first hook with a second hook based on the enclosure going from an open configuration to a closed configuration and the cover is seated in the opening of the housing; and/or for opening the housing: rotating a rotating element in an opening orientation, to: release the first hook from the second hook; and press a cam of the rotating element against the cover to apply a force against the cover in a normal direction, and change the enclosure from the closed configuration to the open configuration.

The following presents a simplified summary of various concepts disclosed herein. This summary is not an extensive overview and is not intended to identify key or critical elements or to delineate the scope of the claims. This summary is not intended to limit or constrain the present disclosure.

Systems, apparatus, and methods are described for sealing and unsealing a housing. The housing may be configured to house a power device. The housing may be sealed using a cover. The housing may be closed and sealed, for example, using snap-fit connectors on the cover and/or housing. The housing may be sealed using the cover and form an ingress protection rated enclosure. The housing and cover may comprise a seal, a seal retainer, a retainer guide, and/or one or more snap-fit connectors. For each snap-fit connector, a rotating element may be incorporated into the housing or cover. Each rotating element may comprise a mechanical element for releasing the snap-fit connection. Each rotating element may comprise one or more cams. Each rotating element may comprise a cam for converting a rotating motion of the rotating element to a linear motion that applies force to the cover from inside the enclosure if the cover is coupled to the housing. By rotating each of the rotating elements, the cover may be released from the housing and removed, and the housing may be unsealed.

There is disclosed an apparatus comprising: a seal; a cover comprising: a surface having a normal direction to the surface, a seal retention structure comprising a seal recess, wherein the seal recess is configured to retain the seal, and a first hook; a housing comprising: an opening and a sealing surface around an edge of the opening, wherein the sealing surface is configured to abut at least a portion of the seal; cover guides; a second hook configured to engage the first hook thereby limiting motion of the cover in the normal direction; and a rotating element comprising: an axis of rotation; and a cover lift cam configured to apply a force to the cover in the normal direction, based on the rotating element being rotated, causing the cover to separate from the housing.

The apparatus may further comprise a closed configuration and an open configuration, wherein in the closed configuration: the cover fills the opening, the sealing surface and the cover guides are configured to compress the seal and the seal retention structure, the first hook is engaged with the second hook, retaining the cover in the opening, and the cover guides are configured to constrain a movement of the seal retention structure in a lateral direction, and wherein in the open configuration the cover and the housing are separated.

The cover guides may further comprise angled surfaces configured to push the seal retention structure toward the sealing surface based on the apparatus changing from the open configuration to the closed configuration.

The rotating element may further comprise a mechanical element and wherein in the closed configuration the mechanical element is configured to separate the first hook from the second hook based on the rotating element being rotated.

The seal recess may further be configured to apply a first force to the seal substantially opposite the normal direction based on a transition from the open configuration to the closed configuration, and wherein the seal recess is configured to apply a second force to the seal in substantially the normal direction based on a transition from the closed configuration to the open configuration.

The closed configuration may further comprise engaging the first hook and the second hook thereby retaining the housing and the cover in the closed configuration.

The rotating element may further be configured to rotate in an opening orientation to change the apparatus from the closed configuration to the open configuration, wherein the rotating element comprises a return spring configured to apply a rotational force to the rotating element, where the rotational force is directed against the opening orientation.

The cover guides may further be configured to apply force to the seal retention structure and press the seal towards the sealing surface in the closed configuration.

The recess may further be configured on a surface of the seal retention structure.

The cover may be configured to fill the opening of the housing.

The rotating element may comprise a tool recess configured to accept a tool, wherein the tool recess comprises a shape that is configured to apply torque to the rotating element based on the tool being rotated.

The second hook may be incorporated into the rotating element.

The second hook may comprise a cantilever and is incorporated into the housing, and wherein the rotating element comprises a release cam configured to: apply a second force to the cantilever, deflect the cantilever and release the second hook from the first hook.

The first hook and the second hook may form a snap-fit attachment.

The first hook and the second hook may form a torsional snap-fit attachment.

The rotating element may be configured to rotate in an opening orientation, wherein the rotating element comprises a cantilever configured to apply a rotational force to the rotating element, where the rotational force is directed against the opening orientation.

The rotating element may be accessible from a hole in the cover, wherein the axis of rotation of the rotating element is substantially parallel to the normal direction.

The rotating element may be accessible from a hole in the housing, and wherein the axis of rotation of the rotating element is substantially perpendicular to the normal direction.

The rotating element may comprise a second seal recess and second seal.

The second seal recess and the second seal may form an ingress protection rated closure between the rotating element and a hole in the cover or a hole in the housing.

In a closed configuration, the seal retention structure, the recess, the sealing surface, and the seal may form an ingress protection rated closure between the cover and the housing by applying force on the seal between the seal retention structure and the sealing surface.

The rotating element may comprise a first part, a second part, and a fastener, and the first part is connected to the second part using the fastener.

The fastener may comprise one or more of a spring clip, a screw, a bolt, a nail, and a rivet.

The seal retention structure may extend from the cover into the housing substantially opposite the normal direction.

The housing may comprise sides and a base, and wherein the seal recess faces the sides of the housing.

The cover may be substantially parallel to the base.

The seal may be hollow.

The rotating element may further comprise rotation guides.

The seal retention structure may follow a perimeter or circumference of the cover.

There is further disclosed an apparatus comprising: a seal; a cover comprising: a surface having a normal direction to the surface, a sealing surface around an edge of the opening, wherein the sealing surface is configured to abut at least a portion of the seal, and a first hook; a housing comprising: an opening, and a seal retention structure comprising a seal recess, wherein the seal recess is configured to retain the seal; cover guides; a second hook configured to engage the first hook thereby limiting motion of the cover in the normal direction; and a rotating element comprising: an axis of rotation; and a cover lift cam configured to apply a force to the cover in the normal direction, based on the rotating element being rotated, causing the cover to separate from the housing.

There is further disclosed a method comprising: sealing a housing with a cover to form an enclosure by pressing the cover onto an opening of the housing, and by: forcing a seal, disposed in a recess of a seal retention structure of the cover, against a sealing surface of the housing via cover guides that press the seal retention structure and the seal towards the sealing surface; and engaging a first hook with a second hook based on the enclosure going from an open configuration to a closed configuration and the cover is seated in the opening of the housing; rotating a rotating element in an opening orientation, to: release the first hook from the second hook; and press a cam of the rotating element against the cover to apply a force against the cover in a normal direction, and change the enclosure from the closed configuration to the open configuration.

There is further disclosed an apparatus comprising: a housing; a cover; and a seal positioned between the cover and the housing; the housing comprising: an opening; and a surface around an edge of the opening; the cover comprising: a surface defining a normal direction to the surface, a seal retention structure comprising a seal recess, wherein the seal recess is configured to retain the seal, and a first hook; a second hook configured to engage the first hook thereby limiting motion of the cover in the normal direction; and a rotating element comprising: an axis of rotation; and a cover lift cam configured to apply a force to the cover in the normal direction based on the rotating element being rotated, causing the cover to separate from the housing.

### BRIEF DESCRIPTION OF THE DRAWINGS

The present disclosure is illustrated by way of example and is not limited in the accompanying figures in which like reference numerals indicate similar elements and in which:
Figure 1 shows a cross-section view schematic illustration of an apparatus comprising a seal and a cover;
Figure 2 shows a perspective view schematic illustration of a seal retention structure;
Figure 3 shows a cross-section view schematic illustration of a housing and cover;
Figure 4 shows a perspective view schematic illustration of a housing and cover;
Figure 5 shows a side view simplified illustration of a rotating element;
Figure 6A and Figure 6B show exploded view schematic illustrations of a rotating element;
Figure 7A and Figure 7B show side view schematic illustrations of a rotating element;
Figure 7C shows a perspective view schematic illustration of a rotating element;
Figure 7D shows a top view schematic illustration of a rotating element;
Figure 8 shows a cross-section view simplified illustration of a housing and cover;
Figure 9 shows a cross-section view schematic illustration of an apparatus comprising a seal and a cover;
Figure 10 shows a side view simplified illustration of a rotating element;
Figure 11 shows a perspective view schematic illustration of a cover;
Figure 12 shows a perspective view schematic illustration of a cover;
Figure 13 shows a flow chart of a method for closing and/or sealing a housing;
Figure 14 shows a flow chart of a method for opening and/or unsealing a housing;
Figure 15 shows a flow chart of a method for opening and/or unsealing a housing;
Figure 16 shows a flow chart of a method for closing and/or sealing and opening and/or unsealing a housing.

### DETAILED DESCRIPTION

In the following description, reference is made to the accompanying drawings, which form a part hereof, and in which are shown, by way of illustration, various examples of the disclosure. It is to be understood that the examples shown and/or described are non-exclusive, and other examples may be practiced, and structural and functional modifications may be made without departing from the scope of the present disclosure.

Although the subject matter has been described in language specific to structural features and/or methodological acts, it is to be understood that the subject matter defined in the appended claims is not necessarily limited to the specific features or acts described herein. Rather, the specific features and acts described herein are disclosed as example forms of implementing the claims.

Apparatuses, systems, and methods are disclosed herein for sealing and unsealing a housing. The housing may be configured to house a power device. The housing may be sealed using a cover. The housing may be closed and sealed using snap-fit connectors on the cover and/or housing. The housing may be sealed using the cover and form an ingress protection rated enclosure. The housing and cover may comprise a seal, a seal retainer, a retainer guide, and one or more snap-fit connectors. For each snap-fit connector, a rotating element may be incorporated into the housing or cover. Each rotating element may comprise a mechanical element for releasing the snap-fit connection. Each rotating element may comprise one or more cams. Each rotating element may comprise a cam for converting a rotating motion of the rotating element to a linear motion that, with the cover coupled to the housing, applies force to the cover from inside the enclosure. By rotating each of the rotating elements, the cover may be released from the housing and removed, and the housing may be unsealed.

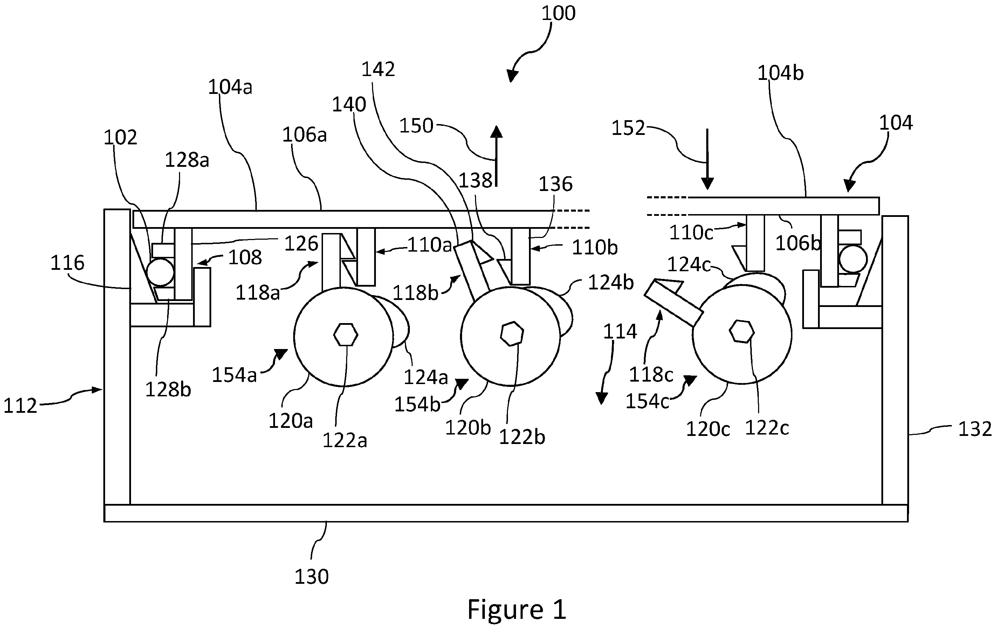

Reference is made to Figure 1, which shows a cross-section view schematic illustration of an apparatus comprising a seal 102 and a cover 104. The apparatus 100 may include a seal 102. The apparatus 100 may include a cover 104. The portions 104a/104b, as depicted in Figure 1, may be different portions of the same cover 104 and depicted as separate for clarity of description and illustration. The apparatus 100 can be in a closed configuration in which the cover fills the opening, as shown on the left side of Figure 1, and in an open configuration in which the cover and the housing are separated, as shown on the right side of Figure 1. The cover may be moved from the closed configuration to the open configuration along a first direction 150 and from the open configuration to the closed configuration along a second direction 152.

The cover 104 includes one or more surfaces 106. The embodiment of Figure 1 shows a planar surface. The cover 104 may also have other surfaces, e.g. curved surfaces or irregular surfaces. The cover 104 includes an outer surface 106a and an inner surface 106b (106a and 106b together generally referred to as surfaces 106) defining a pair of normal directions 150 and 152 relative to the outer surface 106a and the inner surface 106b. The first normal direction 150 is depicted by arrow 150 of Figure 1. The first normal direction 150 points away from the outer surface 106a and away from the interior of the housing 112. The second normal direction 152 is depicted by arrow 152 of Figure 1. The second normal direction 152 points away from the inner surface 106b and towards the interior of the housing 112. The second normal direction 152 may be opposite to the first normal direction 150. The cover 104 includes a seal retention structure 108 comprising a seal recess, wherein the seal recess is configured to retain the seal 102. The seal retention structure 108 of Figure 1 includes a seal retention wall 126 including one or more protuberances 128a/128b (collectively referred to herein as protuberances 128). The protuberances 128 extend from the seal retention wall 126. The protuberances 128 are spaced apart, thereby defining a seal recess. The protuberances 128 are configured to fit the seal 102 between the protuberances 128. Other embodiments may have different seal retention structures having different geometry and structure or fitting more than one seal. The cover 104 includes at least one first hook 1 10a/110b/110c (collectively referred to as first hook 110).

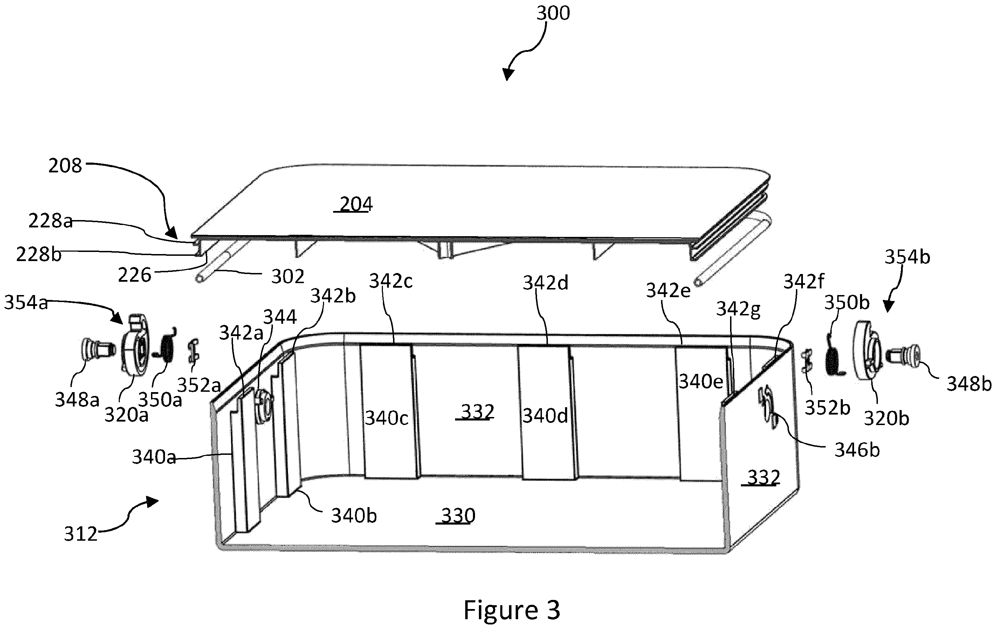

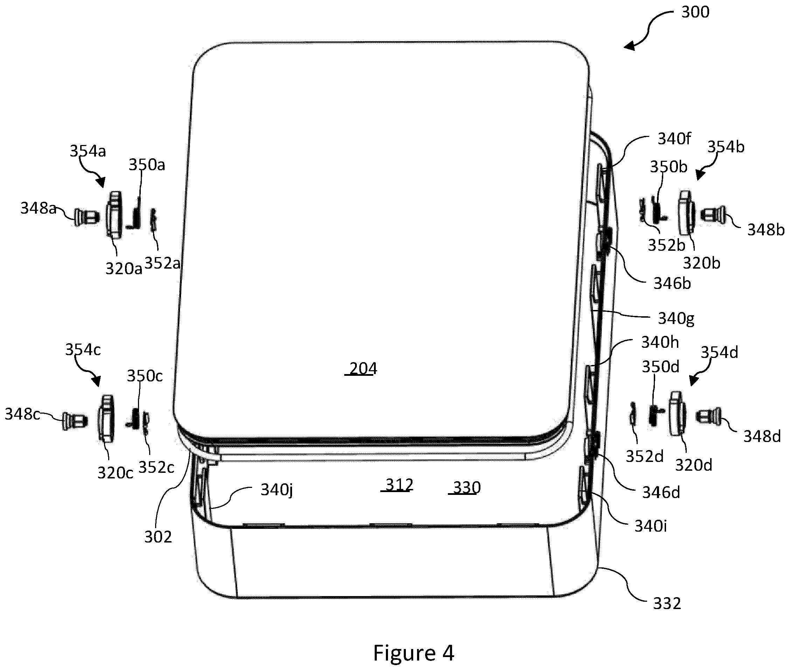

The apparatus 100 includes a housing 112. The housing 112 includes an opening 114. The housing 112 includes a sealing surface 116, for example, around an edge of the opening 114. The sealing surface 116 may face the seal retention structure 108. The sealing surface 116 is configured to abut at least a portion of the seal retention structure 108 and/or the seal 102. The housing 112 may include one or more cover guides 340 (shown, for example, in Figure 3 and Figure 4, and described further below). The apparatus 100 includes at least one second hook 118a/118b/118c (collectively referred to as second hook 118) configured to engage the first hook 110, thereby limiting motion of the cover 104 in the normal direction 150. The apparatus 100 includes at least one rotating element 154a/154b/154c (collectively referred to as rotating element 154). The rotating element 154 includes at least one axis of rotation 122a/122b/122c (collectively referred to as at least one axis of rotation 122). The rotating element 154 includes at least one cover lift cam 124a/124b/124c (collectively referred to as at least one cover lift cam 124) configured to apply a force to the cover 104 if the rotating element 154 is rotated, causing the cover 104 to separate from the housing 112. The cover lift cam 124 may be configured to convert a rotating motion of the rotating element 154 to a linear motion that applies960 force to the cover 104 in the first normal direction 150 if the rotating element 154 is rotated.

The housing 112 may be configured to house and/or support one or more electrical components. For example, the housing 112 may be configured to house a power device, for example, an inverter. The housing 112 may be configured to house a junction box. The housing 112 may include a box or bin. The housing 112 may be rectangular, square, trapezoidal, or the like or any other shape. The housing 112 may be cylindrical, oval, or the like. The housing 112 may include a base 130. The housing 112 may include one or more walls (or sides) 132. The one or more walls (or sides) 132 may be integral with the base 130. For example, the base 130 and the one or more walls 132 may form a single structure and/or may be portions of the same structure. Alternatively, the base 130 and the one or more walls 132 may be formed of separate and joined parts. At least a portion of the base 130 and/or at least a portion of the one or more walls 132 may define the opening 114. The housing 112 may include the opening 114 defined by the one or more walls 132 and/or the base 130. The housing 112 may include the opening 114 in the one or more walls 132 and/or the base 130. The opening 114 may be defined by an aperture, recess, volume, and/or cavity of the housing 112. The one or more walls 132 may include one or more openings configured to fit at least a portion of the rotating element 154, such as described in greater detail elsewhere herein.

The cover 104 is configured to fit, at least partially, into the opening 114. The cover 104 may also be configured to cover the opening 114. The cover 104 is configured to seal the opening 114 in cooperation with the seal 102. If the cover 104 is positioned on the opening 114, the recess and/or the cavity of the housing 112 may be closed off. The opening 114 may be positioned such that if the cover 104 is placed into the opening 114, the cover 104 may be parallel to the base 130 of the housing 112. Additionally or alternatively, the opening 114 may be positioned such that if the cover 104 is placed into the opening 114, the cover 104 may be substantially parallel to the base 130 of the housing 112 (e.g., approximately and/or substantially parallel to the base 130 of the housing 112).

The cover 104 may include a plate. The cover 104 may be rigid, semi-rigid, and/or flexible. The cover 104 includes one or more surfaces 106. The surfaces 106 may be opposite sides of the same object (e.g., the same plate). The surfaces 106 may be part of two or more different objects (e.g., two or more plates). The cover 104 may have an outer surface 106a and an inner surface 106b. The outer surface 106a may be an outer surface of the cover 104, for example, a surface 106 facing away from the interior of housing 112 and/or the opening 114 of the housing 112. The inner surface 106b may be an inner surface of the cover 104, for example, a surface 106 facing the interior of housing 112 and/or the opening 114 of the housing 112. The outer surface 106a may define a first normal direction 150 relative to the outer surface 106a, such as depicted by arrow 150 in Figure 1; for example, the normal direction 150 may be a normal vector or a normal direction. The outer surface 106b may define a second normal direction 152 relative to the inner surface 106b, such as depicted by arrow 152 in Figure 1, for example, the second normal direction 152 may be a normal vector or a normal direction. The first normal direction 150 may be a normal vector facing away from the interior of the housing 112. The second normal direction 152 may be a normal vector facing towards the interior of the housing 112.

The cover 104 may include the seal 102. The seal 104 may for example be integrally connected to the cover 104. The seal 102 may extend along a perimeter of the cover 104. The seal 102 may surround one or more portions of the cover 104. The seal 102 may surround and/or extend on the seal retention structure 108, such as described in greater detail elsewhere herein. The seal 102 may be hollow. The seal 102 may have an annular cross-section. The seal 102 may have an oblong ring-like shape. The seal 102 may be annular. The seal 102 may be an o-ring. The seal 102 may be composed of a semi-rigid and/or flexible material. The seal 102 may be composed of a polymer. The seal 102 may be composed of a rubber. The seal 102 may be composed of silicone and/or a composition comprising silicone.

The cover 104 includes a seal retention structure 108 comprising a seal recess, wherein the seal recess is configured to retain the seal 102. The seal retention structure 108 may extend from the cover 104 in a direction towards the opening 114. The seal retention structure 108 may extend from the cover 104 in the second normal direction 152, e.g., opposing the first normal direction 150. The seal retention structure 108 may extend from the cover 104 in the second normal direction 152 substantially (or approximately) opposing the first normal direction 150. The seal retention structure 108 of Figure 1 includes a seal retention wall 126 including one or more protuberances 128a/128b (collectively referred to herein as protuberances 128). The protuberances 128 extend from the seal retention wall 126. The protuberances 128 are spaced apart, thereby defining a seal recess. The protuberances 128 are configured to fit the seal 102 between the protuberances 128. The seal retention structure can also have a different structure, e.g the seal might fit between a protuberance of the seal retention wall and a surface of the cover. The seal recess may be sized to fit the seal 102 therein. The seal recess may be sized to sealingly fit the seal 102 therein. The seal recess may be sized to hermetically fit the seal 102 therein. Thus, the seal retention structure 108 may be configured to retain the seal 102 and/or configured to constrain movement of the seal 102.

The seal retention structure 108 of Figure 1 is configured to prevent movement of the seal 102 in the first normal direction 150 and the second normal direction 152 relative to the cover 104. The seal retention structure 108 may be configured to constrain movement of the seal 102 in the first normal direction 150 upon cover 104 closure (e.g., if a force is applied to the cover 104 in the second normal direction 152, e.g., opposing the first normal direction 150). The seal retention structure 108 may be configured to constrain movement of the seal 102 in the second normal direction 152 upon cover 104 opening (e.g., if a force is applied to the cover 104 in the first normal direction 150).

The seal retention wall 126 and/or the protuberances 128 may extend around a perimeter of the cover 104. Thus, the seal retention structure 108 may follow a perimeter or circumference of the cover 104. The seal retention wall 126 and/or the protuberances 128 may be positioned on the cover 104 such that if the cover 104 is placed on the housing 112 (e.g., in a manner in which the cover 104 is closing the housing 112), the protuberances 128 may abut the one or more walls 132 and/or the base 130 of the housing 112. The seal retention structure 108 may be configured to abut at least a portion of the housing 112 if the housing 112 and cover 104 are in a closed configuration. The seal recess may be facing the one or more walls 132 of the housing 112 in a closed configuration thereof. The seal retention structure 108 and/or the seal 102 may be configured to abut the sealing surface 116 in a closed configuration, such as described in greater detail elsewhere herein.

The protuberances 128 of the embodiment of Figure 1 extend in a direction substantially parallel to the base 130, for example, a longitudinal axis of the protuberances 128 is substantially parallel to the base 130. Two or more of the protuberances 128 may be symmetrical or asymmetrical. The protuberances 128 may be rigid, semi-rigid, and/or flexible.

The seal recess and/or the seal retention structure 108 may be configured to apply a first force to the seal 102, wherein the first force is in the second normal direction 152, e.g., opposite to the first normal direction 150, during a transition from the open configuration to the closed configuration. The seal recess and/or the seal retention structure 108 may be configured to apply a second force to the seal 102 in the first normal direction 150, e.g., opposite to the second normal direction 152, during a transition from the closed configuration to the open configuration.

In the embodiment of Figure 1, the cover 104 includes the seal retention structure 108, and the housing 112 includes the sealing surface 116. Alternatively or in addition, the housing 112 may include a seal retention structure 108, and the cover 104 may include a sealing surface 116. The cover 104 and the housing 112 may each have at least one sealing surface 116 and at least one seal retention structure 108, wherein each seal retention structure 108 corresponds to a sealing surface 116.

The sealing surface 116 and the seal retention structure 108 may be composed of materials such that if the sealing surface 116 and the seal retention structure 108 are abutting each other, the contact therebetween is sufficient for preventing moisture into the housing 112. For example, the sealing surface 116 and the seal retention structure 108 may have a low surface roughness. The sealing surface 116 and the seal retention structure 108 may adhere to each other. At least one of the sealing surface 116 and the seal retention structure 108 may be composed of a material with a high friction coefficient. For example, the friction coefficient may be greater than about 0.5, greater than about 0.6, greater than about 1, etc. The sealing surface 116 and the seal retention structure 108 may form a hermetic seal between the cover 104 and the housing 112. The sealing surface 116 and the seal retention structure 108 may form an ingress protection rated closure between the cover 104 and the housing 112. Additionally or alternatively, in some examples, the seal 102 may be composed of materials such that if the sealing surface 116 and the seal retention structure 108 are abutting each other, the seal 102 may prevent or assist in preventing moisture into the housing 112. For example, the seal 102 may have a low surface roughness. The seal 102 may adhere to at least a portion of the sealing surface 116 and/or the seal retention structure 108. The seal 102 may be composed of a material with a high friction coefficient. For example, the friction coefficient may be greater than about 0.5, greater than about 0.6, greater than about 1, etc. The seal 102 may form or help form a hermetic seal between the cover 104 and the housing 112. The seal 102 may form or help form an ingress protection rated closure between the cover 104 and the housing 112.

The ingress protection rated closure may include a grade of resistance of the enclosure between the cover 104 and the housing 112, or more specifically, between any two of the sealing surface 116, the seal retention structure 108, and the seal 102, or any combination thereof. The ingress protection rated closure may include a grade of resistance of the enclosure between the cover 104 and the housing 112, which prevents intrusion of dust, liquid, and/or the like. The ingress protection (IP) rated closure may be a specified rating, such as, for example, 67 (or IP67), IP55, IP11, IP68. The IP rated closure may range between IP11 and IP68, or any range therebetween. The IP rated closure may be IP69K. The solid particle protection of the IP rated closure may range between 0 and 6 (and/or 6P). The liquid ingress protection of the IP rated closure may range between 0 and 8.

The sealing surface 116 and the seal 102 may be composed of materials such that if the sealing surface 116 and the seal 102 are abutting each other, the contact therebetween is sufficient for preventing moisture into the housing 112. For example, the sealing surface 116 and the seal 102 may have a low surface roughness. Additionally or alternatively, the sealing surface 116 and the seal 102 may adhere to each other. At least one of the sealing surface 116 and the seal retention structure 108 may be composed of a material with a high friction coefficient. For example, the friction coefficient may be greater than about 0.5, greater than about 0.6, greater than about 1, etc. The sealing surface 116 and the seal 102 may form a hermetic seal between the cover 104 and the housing 112. The sealing surface 116 and the seal 102 may form an IP rated closure between the cover 104 and the housing 112.

The seal 102 and the seal retention structure 108 may be composed of materials such that if the seal 102 and the seal retention structure 108 are abutting each other, the contact therebetween is sufficient for preventing moisture into the housing 112. For example, the seal 102 and the seal retention structure 108 may have a low surface roughness. Additionally or alternatively, the seal 102 and the seal retention structure 108 may adhere to each other. At least one of the seal 102 and the seal retention structure 108 may be composed of a material with a high friction coefficient. For example, the friction coefficient may be greater than about 0.5, greater than about 0.6, greater than about 1, etc. The seal 102 and the seal retention structure 108 may form a hermetic seal between the cover 104 and the housing 112. The seal 102 and the seal retention structure 108 may form an IP rated closure between the cover 104 and the housing 112.

Thus, the seal retention structure 108, the seal recess, the sealing surface 116, and the seal 102 may form an IP rated closure between the cover 104 and the housing 112 by applying force on the seal 102 between the seal retention structure 108 and the sealing surface 116 with the apparatus in the closed configuration.

The cover 104 includes at least one first hook 110a/110b/110c (collectively referred to as first hook 110). The first hook 110 may be rigid or semi-rigid. The first hook 110 may extend from the inner surface 106b of the cover 104. The first hook 110 may extend in the second normal direction 152, e.g., substantially (or approximately) opposite to the first normal direction 150. The first hook 110 may extend away from inner surface 106b of the cover 104, for example, towards the housing 112 (e.g., towards the base 130 of housing 112). The first hook 110 may extend at an angle of between about 0 degrees and about 90 degrees in relation to the cover 104 (or one of the surfaces of the cover 104).

In the embodiment of Figure 1, the first hook 110 includes a first rod extending from the cover 104, such as, for example, first rod 136. The first hook 110 includes a first claw extending from the first rod 136, such as, for example, first claw 138. The first rod 136 may be rigid or semi-rigid. In some examples the first rod 136 may include a rigid portion and a semi-rigid portion. The different portions may be composed of different materials or the same material. The different portions may have different sizes or diameters. The first rod 136 may be rigidly attached to the cover 104. The first rod 136 may extend at an angle of between about 0 degrees and about 90 degrees in relation to the cover 104. The first rod 136 may comprise a lever configured to leverage the force applied thereto, such as described in greater detail elsewhere herein. The first rod 136 may be coupled to the first claw 138. The first rod 136 and the first claw 138 may be integral (e.g., the first rod 136 and the first claw 138 may be two portions of a single unit). The first hook 110 may be formed as a part of the seal retention structure 108.

In the embodiment of Figure 1, the second hook 118 includes a second rod extending from the rotating element 154, such as, for example, second rod 140, which may be similar to first rod 136. The second hook 118 includes a second claw 142 extending from the second rod 140, such as, for example, second claw 142, which may be similar to first claw 138. The second rod 140 may be rigid or semi-rigid. In some examples the second rod may include a rigid portion and a semi-rigid portion. The different portions may be composed of different materials or the same material. The different portions may have different sizes or diameters. The second rod 140 may be rigidly attached to the rotating element 154. The second rod 140 may extend at an angle of between about 0 degrees and about 90 degrees in relation to the rotating element 154. The second rod 140 may comprise a lever configured to leverage the force applied thereto, such as described in greater detail elsewhere herein. The second rod 140 may be coupled to the second claw 142. The second rod 140 and the second claw 142 may be integral (e.g., the second rod 140 and the second claw 142 may be two portions of a single unit).

In the embodiment of Figure 1, the first claw 138 extends from the first rod 136. The first claw 138 may extend at an angle of between about 0 degrees and about 180 degrees in relation to the first rod 136. The first claw 138 may extend at an angle of between about 0 degrees and about 90 degrees in relation to the first rod 136. The first claw 138 may be a grapple or a grapple hook. The first claw 138 may be rigid or semi-rigid. The first claw 138 may be shaped to contact the second hook 118. The second claw 142 may extend from the second rod 140. The second claw 142 may extend at an angle of between about 0 degrees and about 180 degrees in relation to the second rod 140. The second claw 142 may extend at an angle of between about 0 degrees and about 90 degrees in relation to the second rod 140. The second claw 142 may be a grapple or a grapple hook. The second claw 142 may be rigid or semi-rigid. The second claw 142 may be shaped to contact the first hook 110. The first claw 138 of the first hook 110 may be configured to abut the second claw 142 of the second hook 118, or vice versa. The first claw 138 of the first hook 110 may be configured to oppose movement of the second claw 140 of the second hook 118, or vice versa. Thus, in a closed configuration, the first claw 138 of the first hook 110 may correspond to the second claw 142 of the second hook 118 by resisting a movement of the second hook 118, or vice versa. The corresponding claws 138, 142 may be configured to prevent movement of the cover 104 in the first normal direction 150, thus preventing a movement of the cover from the closed configuration to the open configuration of the apparatus. The first hook 110 and the second hook 118 may be shaped to engage one another. The first hook 110 and the second hook 118 may be shaped and sized to prevent movement of each other. The first hook 110 and the second hook 118 may be configured to form a snap-fit attachment, for example, the first hook 110 and the second hook 118 may be configured to fit each other. In the embodiment of Figure 1, the first hook 110 and second hook 118 are shaped so that the first hook 110 pushes the second hook 118 out of place when the cover is moved in the second normal direction 152, i.e. the direction from the open configuration to the closed configuration. Once the cover 104 is in the closed configuration, the first hook 110 and the second hook 118 engage one another and movement from the closed configuration to the open configuration is prevented unless the second hook 118 is actively disengaged from the first hook 110. The first hook 110 and the second hook 118 may comprise geometrically complementary shapes. The first hook 110 and the second hook 118 may form a torsional snap-fit attachment. The number of first hooks 110 may be equal to the number of second hooks 118. The number of first hooks 110 may be larger than the number of second hooks 118. The number of first hooks 110 may be smaller than the number of second hooks 118.

The housing 112 includes a sealing surface 116 around an edge of the opening 114. The sealing surface 116 faces the seal retention structure 108. The sealing surface 116 is configured to abut at least a portion of the seal retention structure 108 and/or the seal 102. The sealing surface 116 may be positioned on one or more of the walls 132 of the housing 112. In the embodiment of Figure 1, the sealing surface 116 is located on an inner portion of the one or more walls 132. Alternatively or in addition, a sealing surface may be located on a portion of the housing that faces the outside of the housing, such as a top surface facing essentially in the first normal direction 150. The sealing surface 116 may be located on an inner surface of the one or more walls 132, wherein the inner surface of the one or more walls 132 is inside the housing 112. The sealing surface 116 may extend along a length of one or more of the walls 132. The sealing surface 116 may extend along at least a portion of the length of one or more of the walls 132. The sealing surface 116 may be located on one or more edges of the one or more walls 132.

The sealing surface 116 and/or the seal 102 may be composed of a silicone or rubber. The sealing surface 116 and/or the seal 102 may be composed of a material that is resistant to abrasion and/or tearing. The sealing surface 116 and/or the seal 102 may be composed of a material configured to accommodate pressure applied thereon, for example, enabling a sealing connection to be formed between the housing 112 and the cover 104 based on the seal 102 of the cover 104 applying a pressure to the sealing surface 116.

The sealing surface 116 may be triangular and/or slanted. The sealing surface 116 may also be rectangular and/or trapezoid shaped. The sealing surface 116 may be angled, such as depicted in Figure 1. The sealing surface 116 may be angled at an angle of between about 1 degree and about 90 degrees. The sealing surface 116 may be angled at an angle of between about 1 degree and about 15 degrees. The sealing surface 116 may be angled at an angle of between about 1 degree and about 30 degrees. The sealing surface 116 may be angled at an angle of between about 0.5 degrees and about 5 degrees. The sealing surface 116 may be shaped to receive the seal retention structure 108.

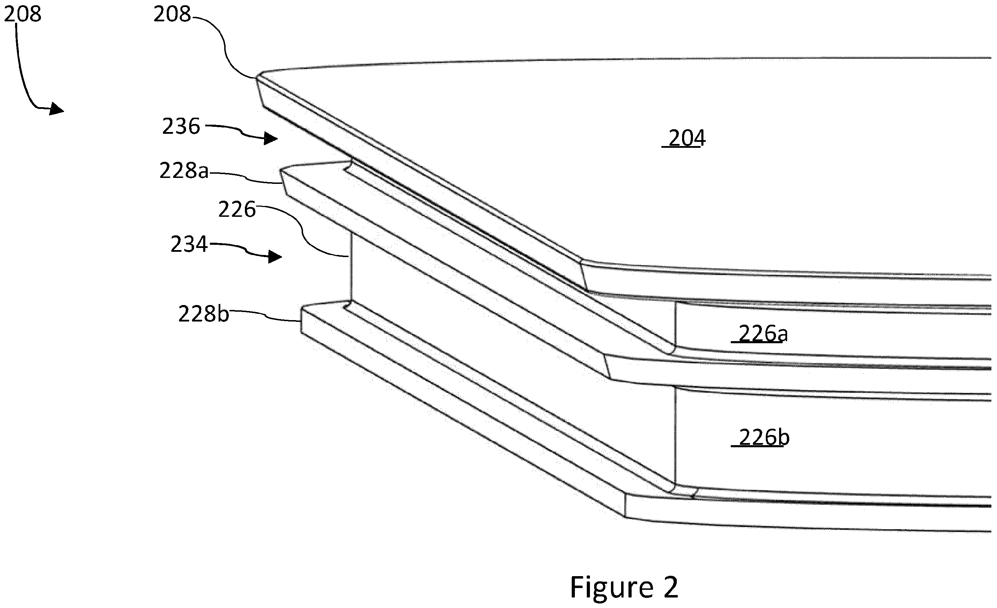

Reference is made to Figure 2, which shows a perspective view schematic illustration of an example seal retention structure. The seal retention structure 208 of Figure 2 may be similar to and/or include one or more characteristics of the seal retention structure 108 of Figure 1 as described herein. Alternatively, the seal retention structure 108 of Figure 1 may be similar to and/or include one or more characteristics of seal retention structure 208 of Figure 2. The cover 204 of Figure 2 may be similar to and/or include one or more characteristics of the cover 104 of Figure 1. Alternatively, the cover 104 of Figure 1 may be similar to and/or include one or more characteristics of cover 204 of Figure 2.

The seal retention structure 208 of Figure 2 extends from the cover 204. The seal retention structure 208 includes a wall 226 including one or more protuberances 228a/228b (collectively referred to herein as protuberances 228). The wall 226 includes a first portion 226a exposed between two or more protuberances 228a/228b. The wall 226 further includes a second portion 226b exposed between the protuberances 228 and the cover 204. The protuberances 228 extend outwards from the wall 226. The protuberances 228 extend in a direction that is parallel or substantially parallel to the cover 204. The protuberances 228 may be configured to limit a movement of the seal. The protuberances 228 are spaced apart, thereby defining a seal recess 234. The seal recess 234 may be configured to fit the seal (e.g., the seal 102) therein.

Reference is made to Figure 3, which shows a cross section view schematic illustration of an example housing and cover, and to Figure 4, which shows a perspective view schematic illustration of an example housing and cover. The cover 204, depicted in Figure 3 and/or Figure 4, may include one or more aspects of the cover 104 of Figure 1 as described herein. Alternatively, the cover 104 of Figure 1 may be similar to and/or include one or more characteristics of the cover 204 of Figure 3 and/or Figure 4. The housing 312, depicted in Figure 3 and/or Figure 4, may include one or more aspects of the housing 112. Alternatively, the housing 112 of Figure 1 may be similar to and/or include one or more characteristics of the housing 312 of Figure 3 and/or Figure 4. The seal 302 of Figure 3 and/or Figure 4 may be similar to and/or include one or more characteristics of the seal 102 of Figure 1. Alternatively, the seal 102 of Figure 1 may be similar to and/or include one or more characteristics of the seal 302 of Figure 3 and/or Figure 4.

The housing 312 of Figures 3 and 4 includes a plurality of cover guides 340a/340b/340c/340d/340e /340f/340g/340h/340i/340j (collectively referred to herein as one or more cover guides 340). Alternatively, some of the cover guides could be combined into one structural cover guide or a single cover guide could be provided. The one or more cover guides 340 are configured to constrain a movement of the seal retention structure 208 in a lateral direction. The one or more cover guides 340 may also be referred to as retainer guides. The one or more cover guides 340 may be configured to constrain a movement of the cover 204 in a lateral direction. The lateral direction may be perpendicular to the first normal direction 150 and/or the second normal direction 152. The one or more cover guides 340 of Figures 3 and 4 includes an elongated element attached to or integrally formed with the housing 112. The one or more cover guides 340 may include a rod, a plate, or the like.

The one or more cover guides 340 may be attached to the one or more walls 332 of the housing 312. The one or more cover guides 340 may be rigid and/or rigidly attached to the housing 312. The one or more cover guides 340 may extend towards a top of the housing 312, wherein the top of the housing 312 may be opposing the base 330 of the housing 312. The top of the housing 312 may be similar to or the same as opening 114. The top of the housing may include at least a portion of the opening 114. The one or more cover guides 340 may extend towards a portion of the housing 312 and/or a portion of the one or more walls 332 of the housing 312 which may be configured to receive the cover 204. The one or more cover guides 340 may be shaped such that a recess is formed between at least a portion of the one or more cover guides 340 and the housing 312 and/or the walls 332 of the housing 312. The one or more cover guides 340 may be positioned interior of the seal retention structure 208 at a closed configuration of the cover 204. The seal retention structure 208 may be sandwiched between the one or more cover guides 340 and the housing 312 and/or the walls 332 of the housing 312.

The one or more cover guides 340 may include one or more first ends 342a/342b/342c/342d/ 342e/342f/342g (collectively referred to herein as one or more first ends 342). The one or more first ends 342 may be located at the top portion of the one or more cover guides 340, for example, at an end of the one or more cover guides 340 opposing the base 330 of the housing 312. The first ends 342 may be configured to receive and/or fit therein at least a portion of the cover 204 and/or the seal retention structure 208. The one or more first ends 342 may include a slit configured to fit at least a portion of the cover 204 therein. The one or more first ends 342 may include a gap configured to fit at least a portion of the cover 204 therein, such that at least a portion of the cover 204 is positioned between the one or more first ends 342 and the housing 312. The one or more first ends 342 may be shaped such that a recess is formed between at least a portion of the one or more cover guides 340 and the housing 312 and/or the walls 332 of the housing 312.

The one or more first ends 342 preferably include an angled surface. The one or more first ends 342 can thus be configured to push the seal retention structure toward the sealing surface based on the apparatus changing (or moving) from an open configuration to a closed configuration. The one or more cover guides 340 may be configured to apply a force to the seal retention structure 208 and press the seal 302 towards the sealing surface if in the closed configuration. Thus, in some example configurations, the force between the seal 302 and the sealing surface may be indirect.

The one or more cover guides 340 and/or the first ends 342 may be configured to receive at least a portion of the cover 204. The one or more cover guides 340 and/or the first ends 342 may be shaped to fix the position of at least a portion of the cover 204. The one or more cover guides 340 and/or the first ends 342 may be shaped to fix the position of at least a portion of the seal retention structure 208. The one or more cover guides 340 and/or the first ends 342 may be shaped to fix the position of at least a portion of the wall 226 and/or at least a portion of the protuberances 228. The one or more cover guides 340 and/or the first ends 342 may be configured to fit therein at least one of: at least a portion of the cover 204, at least a portion of the seal retention structure 208, at least a portion of the wall 226, and/or at least a portion of the protuberances 228.

At least a portion of the cover 204, at least a portion of the seal retention structure 208, at least a portion of the wall 226, and/or at least a portion of the protuberances 228, may be configured to fit between at least a portion of the one or more cover guides 340 and the housing 312 and/or the sealing surface. At least a portion of the cover 204, at least a portion of the seal retention structure 208, at least a portion of the wall 226, and/or at least a portion of the protuberances 228, may be configured to fit between at least a portion of the first ends 342 and the housing 312 and/or the sealing surface.

At least a portion of the cover 204, at least a portion of the seal retention structure 208, at least a portion of the wall 226, and/or at least a portion of the protuberances 228, may be configured to fit between the one or more cover guides 340 and the walls 332 of the housing 312 and/or the sealing surface. At least a portion of the cover 204, at least a portion of the seal retention structure 208, at least a portion of the wall 226, and/or at least a portion of the protuberances 228, may be configured to fit between the first ends 340 and the walls 332 of the housing 312 and/or the sealing surface. The one or more cover guides 340 may be shaped to attach to at least a portion of the cover 204, at least a portion of the seal retention structure 208, at least a portion of the wall 226, and/or at least a portion of the protuberances 228. The one or more cover guides 340 may include a hook, a clasp, or a latch.

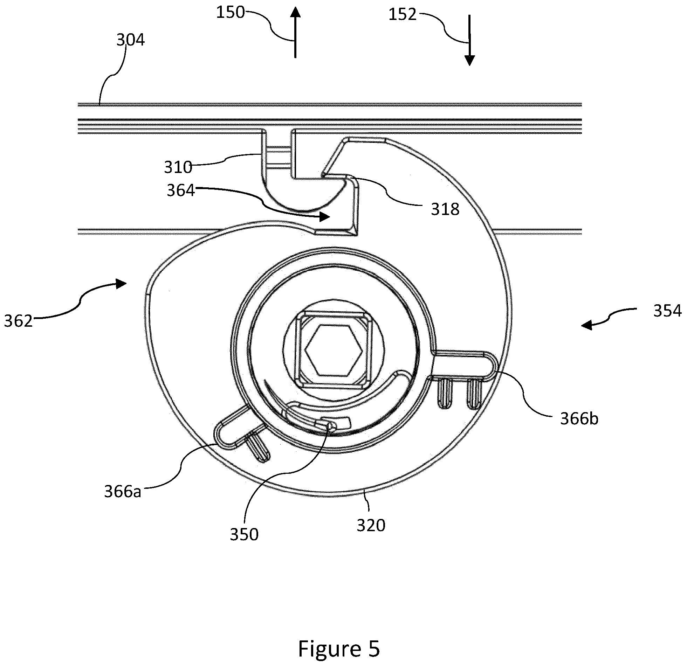

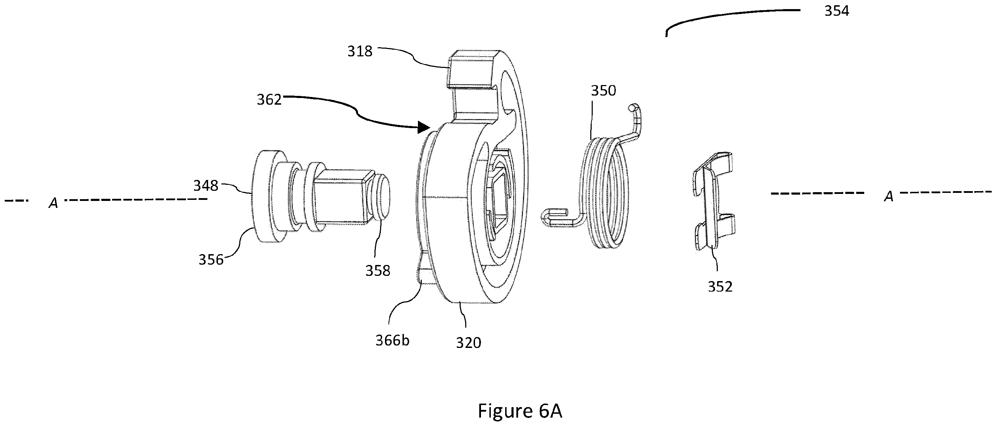

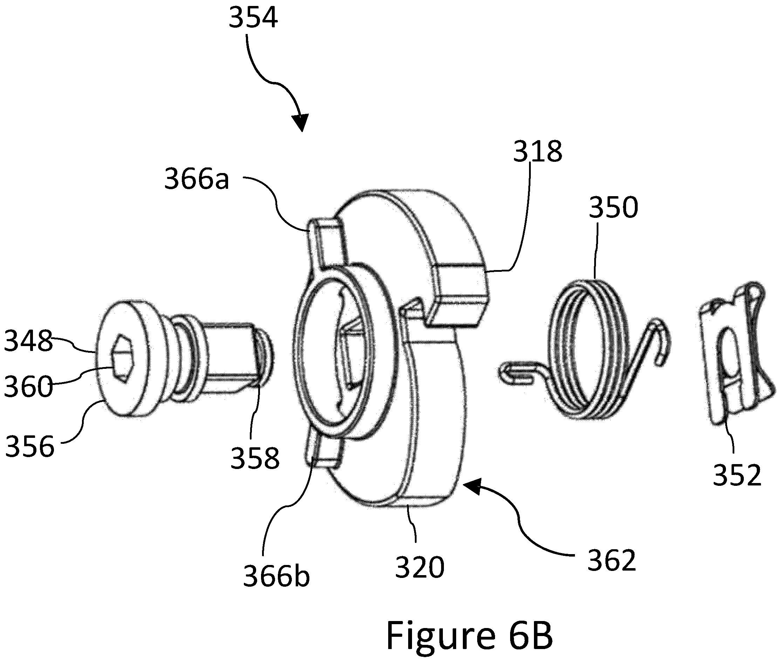

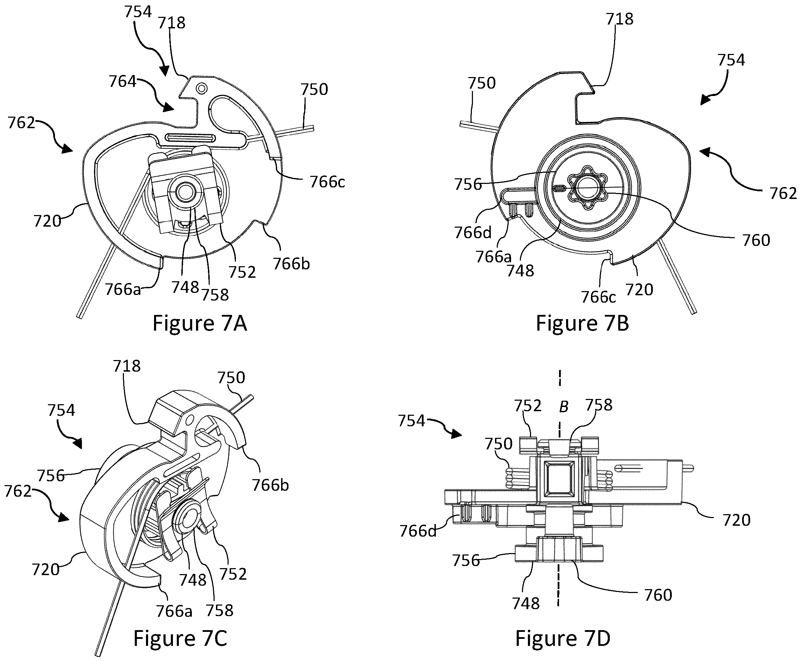

Reference is made to Figure 5, which shows a side view simplified illustration of an example rotating element, and to Figure 6A and Figure 6B, which show exploded view schematic illustrations of an example rotating element, and to Figure 7A, Figure 7B, Figure 7C, and Figure 7D, which show side views, perspective view, and top view schematic illustrations of an example rotating element. Reference will also be made to elements that are shown in Figure 3 and Figure 4.

The apparatus 100/300 includes at least one rotating element 154/354/754 (collectively referred to as rotating element 354/754 or rotating element 154/354/754). The at least one rotating element 354/754 is coupled to (or configured to be coupled to) the housing 312 and/or the wall 332 of the housing 312. The at least one rotating element 354/754 may be located on an inner side of the wall 332, for example, the at least one rotating element 354/754 may be positioned inside the housing 312. The rotating element 354/754 includes a rotating portion 320/720. The rotating element 354/754 has an axis of rotation, such as the axis A depicted in Figure 6A, or the axis B depicted in Figure 7D. The rotating element 354/754 includes a shaft 348/748 configured to abut the rotating portion 320/720. The shaft 348/748 is configured to apply a force to a spring 350/750. Alternatively, a force applied to the shaft may be transferred directly to the rotating portion. The rotating element 354/754 includes the spring 350/750, wherein the spring 350/750 is configured to transfer the force applied to the shaft 348/748 to the rotating portion 320/720. Alternatively a spring may be provided between the rotating element and the housing which biases the rotating element in a rotation direction. The rotating element 354/754 may include a clip 352/752 configured to secure any one or more of the rotating portion 320/720, the spring 350/750, the shaft 348/748, and/or other portions of the rotating element 354/754.

The rotating element 354/754 has an axis of rotation, such as the axis A depicted in Figure 6A, or the axis B depicted in Figure 7D. The axis of rotation of the rotating element 354/754 may be perpendicular to a normal direction 150, 152 of a surface 106 of the cover. The axis of rotation of the rotating element 354/754 may be parallel or substantially parallel to a surface 106 of the cover 104/204. The axis of rotation of the rotating element 354/754 may define the axis about which any one or more of the shaft 348/748, the rotating portion 320/720, the spring 350/750, and/or the clip 352/752 may rotate.

At least a portion of the rotating element 354/754 may be positioned in an opening of the one or more walls 332 of the housing 312. The shaft 348/748 may be positioned in an opening of the one or more walls 332 of the housing 312. The shaft 348/748 may fit into the opening of the one or more walls 332. The shaft 348/748 may seal the opening of the one or more walls 332, thereby preventing fluid flow and/or moisture through the opening of the one or more walls 332. Thus, the shaft 348/748 may include an external end 356/756 exposed to the exterior of the housing 312, for example, exposed to the vicinity outside of the housing 312. The shaft 348/748 may include an internal end 358/758 located inside the housing 312. The shaft 348/748 may be a crankshaft configured to rotate the rotating portion 320/720.

The rotating element 354/754 may be positioned on the cover 204. The apparatus may include a plurality of rotating elements, in which at least a portion are positioned on the walls 332 of the housing 312 and a portion are located on the cover 204. The rotating element 354/754 on the cover may be positioned in an opening of the cover 204. The shaft 348/748 may be positioned in an opening of the cover 204. The shaft 348/748 may fit into the opening of the cover 204. The shaft 348/748 may seal the opening of the cover 204, thereby preventing fluid flow and/or moisture through the opening of the cover 204 exposed to the outer surface of the cover 204, for example, exposed to the vicinity outside of the cover 204. The shaft 348/748 may include an internal end 358/758 located inside the housing 312, for example, on an inner surface of the cover 204.

The axis of rotation of the rotating element 354/754 may be parallel to a normal direction 150, 152 (of a surface 106 of the cover). The axis of rotation of the rotating element 354/754 may be perpendicular or substantially perpendicular to a surface 106 of the cover 104/204 (and/or the cover 104/204).

The external end 356/756 is shaped to receive a tool, wherein the tool is configured to apply a rotational force to the shaft 348/748 and/or the external end 356/756 thereof. The external end 356/756 may include a recess 360/760 configured to receive the tool. For example, the recess 360/760 may be configured to fit a head of the tool, such as a screwdriver. Alternatively, the external end 356/756 may include a protuberance configured to fit into the tool. For example, the protuberance may be configured to fit into a recess of the tool. If the tool is coupled to the shaft 348/748 and/or the external end 356/756 thereof via the recess 360/760 and/or the protuberance, a force applied by the tool to the shaft 348/748 may cause a movement thereof. The force applied to the shaft 348/748 and/or the external end 356/756 thereof by the tool may be rotational or linear. The force applied to the shaft 348/748 and/or the external end 356/756 thereof by the tool may be torque (or a rotation force, in other words, which may cause a rotational movement to the shaft 348/748 and/or the external end 356/756 thereof). The recess 360/760 may include a slot configured to receive the tool. The recess 360/760 may be shaped to receive a standard tool, such as a flat screwdriver. The recess 360/760 may be shaped to receive a specific type of tool, such as a star shaped tool head. In some examples, the external end may be shaped for rotation by hand without a tool. In some examples, the external end may be rotated by a mechanism that receives wired or wireless signals.

The shaft 348/748 may be positioned such that the longitudinal axis of the shaft 348/748 is substantially coaxial and/or parallel to the axis of rotation of the rotating element 354/754. The shaft 348/748 may be configured to abut the rotating portion 320/720. The shaft 348/748 may be configured to apply a force to a spring 350/750, such as the force received from the tool such as described in greater detail elsewhere herein. The spring 350/750 may be a torsion spring. The spring 350/750 may be coupled to the rotating portion 320/720 such that a torque applied to the spring (e.g., for example, by the shaft 348/748) is applied to the rotating portion 320/720.

The rotating element 354/754 may be rotated in an opening orientation (for example, the rotating element 354/754 is rotated in order to remove the cover 204 from the housing 312) to change the apparatus from the closed configuration to the open configuration. The spring 350/750 is configured to apply a rotational force to the rotating element 354/754, wherein the rotational force is directed against the opening orientation. The spring 350/750 therefore helps to force the rotating element away from the opening orientation until a greater external force is applied to move the rotating element into the opening orientation.

The rotating element 354/754 may include a cantilever configured to apply rotational force to the rotating element 354/754, where the rotational force may be directed against the opening orientation. This may be an alternative to a return spring 350/750 in the rotating mechanism. The cantilever may be elastic and may be configured to bend if the rotating element 354/754 is rotated in the opening orientation, thereby applying a force against the opening orientation (for example, retaining the rotating element from rotating).

The rotating element 354/754 includes a clip 352/752 configured to secure any one or more of the rotating portion 320/720, the spring 350/750, the shaft 348/748, and/or other portions of the rotating element 354/754. The clip 352/752 is configured to prevent the spring 350/750 from detaching from the rotating portion 320/720. The clip 352/752 may be a fastener. The clip 352/752 may be configured to connect between the rotating portion 320/720 and the shaft 348/748. The clip 352/752 may include one or more of a spring clip, a screw, a bolt, a nail, and a rivet.

The rotating portion 320/720 comprises a cam. The rotating portion 320/720 may include one or more projections 362/762 and/or depressions. The cam may be circular (round shaped), oval shaped, eccentric, elliptical, pear shaped, snail shaped, heart shaped, hexagonal shaped, star shaped, and/or the like. The cam may be a cover lift cam configured to apply a force to the cover 204, e.g., in the first normal direction 150 based on the rotating element 354/754 being rotated, causing the cover 204 to separate from the housing 312. For example, the cam of the rotating portion 320 may be, e.g., substantially snail shaped, as depicted in Figure 5. The one or more projections 362/762 may be characterized in that the perimeter near or at the one or more projections 362/762 may be further away from the axis of rotation of the rotating portion 320/720, in comparison to the distance between the axis of rotation and the perimeter near or at non-projection areas of the rotating portion 320/720. The one or more projections 362/762 may have a greater radius than other non-projection areas of the rotating portion 320/720.

The rotating element 354/754 may include one or more rotation guides 366a/366b/766a/766b/766c/766d (collectively referred to herein as one or more rotation guides 366/766). The one or more rotation guides 366/766 may be configured to slide along a guide 346b or stopper 344 on an inner wall of the housing. The one or more rotation guides 366/766 may include a stopper configured to prevent movement of the rotating element 354/754 past a certain degree of rotation. The one or more rotation guides 366/766 may be configured to prevent rotation of the rotating element 354/754 in a clockwise direction, a counterclockwise direction, or both. The one or more rotation guides 366/766 may be configured to abut a stopper 344 located on the wall of the housing.

The one or more rotation guides 366a/366b/766d protrude from a first surface of the rotating portion 320/720. The first surface of the rotating portion 320/720 is substantially perpendicular to the axis of rotation of the rotating portion 320/720. The first surface of the rotating portion 320/720 may be facing inwards (e.g., towards the inner cavity of the housing). The first surface of the rotating portion 320/720 may be facing outwards (e.g., towards the wall of the housing).

The one or more rotation guides 766 may be integral with the shape of the rotating portion 320/720, such as depicted in Figures 7A-7D. The one or more rotation guides 766 may be formed by one or more recesses and/or protuberances in a perimeter of the rotating portion 320/720. The one or more rotation guides 766 may be formed by one or more recesses and/or protuberances in a body of the rotating portion 320/720.

The rotating element 354/754 and/or the rotating portion 320/720 may include a mechanical element wherein in the closed configuration the mechanical element is configured to separate the first hook 110/310 from the second hook 118/318//718 if the rotating element is rotated using the tool. The mechanical element may be the cam and/or the one or more projections 362/762. The mechanical element may be a rod or lever. The mechanical element may be coupled to the rotating element 354/754 and/or the rotating portion 320/720.

The apparatus 100/300 includes at least one second hook 118/318/718 (collectively referred to as second hook 118/318/718 or second hook 318/718) configured to engage the first hook 110 thereby limiting motion of the cover 104/204/304 in the first normal direction 150. The rotating element 154/354/754 may include the second hook 118/318/718.

The rotating element 354/754 includes a second hook 118/318/718. The second hook 118/318/718 of this embodiment is shaped as a protuberance or recess coupled to the rotating portion 320/720. The second hook 118/318/718 may be a protuberance in the rotating portion 320/720. The second hook 118/318/718 may be a protuberance extending from the rotating portion 320/720. The second hook 118/318/718 may be formed by creating a recess 364/764 in the rotating portion 320/720, wherein the recess 364/764 and the protuberance share one or more walls.

The rotating element 354/754 includes the second hook 318/718 configured to engage the first hook 110/310. The second hook 318/718 may be incorporated into the rotating element 354/754. The second hook 318/718 may include a mechanical element coupled to a base, wherein the base is coupled to the rotating element 354/754. The second hook 318/718 may include a cantilever.

Alternatively, the second hook 318/718 and/or the cantilever may be incorporated into the housing 112/312. The rotating element 354/754 may include a release cam configured to apply a second force to the cantilever or second hook, thereby deflecting the cantilever and releasing the second hook 118/318/718 from the first hook 110/310.

The at least one second hook 118/318/718 may include a rod extending from the rotating element 354/754, such as, for example second rod 140. The at least one second hook 118/318/718 may include a claw extending from the rod, such as, for example, second claw 142. The rod may be rigid or semi-rigid. In some examples the rod may include a rigid portion and a semi-rigid portion. The different portions may be composed of different materials or the same material. The different portions may have different sizes or diameters. The rod may be rigidly attached to the rotating element 354/754. The rod may extend at an angle of between about 0 degrees and about 90 degrees in relation to the rotating element 354/754. The rod may be a lever configured to leverage the force applied thereto, such as described in greater detail elsewhere herein. The rod may be coupled to the claw. The rod and the claw may be integral (e.g., the rod and the claw may be two portions of a single unit).

The claw may extend from the rod. The claw may extend at an angle of between about 0 degrees and about 180 degrees in relation to the rod. The claw may extend at an angle of between about 0 degrees and about 90 degrees in relation to the rod. The claw may be a grapple or a grapple hook. The claw may be rigid or semi-rigid. The claw may be shaped to contact the first hook 110/310. A first claw of the first hook 110/310 may be configured to abut a second claw of the second hook 118/318/718, such as described in greater detail elsewhere herein.

The first hook 110/310 and the second hook 318/718 may be shaped to engage one another. The first hook 110/310 and the second hook 318/718 may be shaped and sized to prevent movement of each other. The first hook 110/310 and the second hook 318/718 may be configured to form a snap-fit attachment, for example, the first hook 110/310 and the second hook 318/718 may be configured to fit each other. The first hook 110/310 and the second hook 318/718 may comprise geometrically complementary shapes. The first hook 110/310 and the second hook 318/718 may form a torsional snap-fit attachment. The number of first hooks 110/310 may be equal to the number of second hooks 118/318/718. The number of first hooks 110/310 may be larger than the number of second hooks 118/318/718. The number of first hooks 110/310 may be smaller than the number of second hooks 118/318/718.

The rotating element 354/754 includes a recess 364/764 configured to receive the first hook 310/110. The recess 364/764 is located along a perimeter of the rotating portion 320/720. The recess 364/764 may be part of any one or more of the rotating portion 320/720, the spring 350/750, the clip 352/752, and the shaft 348/748.

The shaft 348/748 may include a second recess configured to receive one or more of the other components of the rotating element 354/754 (e.g., such as, but not limited to, the rotating portion 320/720, the spring 350/750, the clip 352/752, and the like. The shaft 348/748 may include a second seal. The second seal may be annular. The second seal may be configured to seal a space between the shaft 348/748 and one or more of the other components of the rotating element 354/754. The second recess and the second seal may form an IP rated closure between the rotating element 354/754 and a hole in the cover or a hole in the housing. The protection rated closure may be designed to seal the second recess. In examples where the recess is configured to receive a second seal, the second recess may also be referred to as a second seal recess.

The rotating element 154/354/754 may be configured to receive a tool in one or more recesses thereof (or a specified tool recess of the rotating element 154/354/754). The rotating element 154/354/754 may be configured to fit the tool therein. The tool may be a mechanical tool configured to apply torque to the rotating element, such as, for example, a lever or screwdriver. The tool may be specialized (or individually shaped to specifically fit the shape of the recess of the rotating element 154/354/754), such as, for example, a star head screwdriver. The torque applied to the rotating element 154/354/754 using the tool may be configured to separate the first hook 110/310 from the second hook 118/318/718 (at a closed configuration of the apparatus). The tool recess may be located on the shaft 348/748. The tool recess may be exposed from an outer wall of the housing of the apparatus. The tool recess may have a shape that is configured to apply torque to the rotating element tool if the tool is rotated.

The rotating element 154/354/754 may include a cantilever configured to apply rotational force to the rotating element 154/354/754, where the rotational force may be directed against the opening orientation. This may be an alternative to the return spring 350/750 in the rotating mechanism. The cantilever may be elastic and may be configured to bend if the rotating element 154/354/754 is rotated in the opening orientation, thereby applying a force against the opening orientation (for example, retaining the rotating element from rotating).

In Fig. 5, the rotating element 354 is shown in the closed configuration of the apparatus with the first hook 310 and the second hook 318 engaging with each other in a locked position in which the cover cannot be moved in the first direction 150 so that the cover 304 cannot be moved into the open configuration. When the rotating element 354 is rotated clock-wise, the second hook 318 initially disengages the first hook 310 in a first stage. In a second stage, upon further rotation, the projection 362 forming the cam contacts the backside of the first hook 310 and pushes the first hook 310 and the cover 304 upwards, thus applying a force to the cover 308 in the first direction 150, based on the rotating element being rotated, causing the cover 308 to separate from the housing. Rotation of the rotating element 354 therefore includes and unlocking stage in which the first and second hooks 310, 318 are disengaged and a subsequent separation stage in which the force is applied to the cover 304 for separation from the housing.

The cam may further comprise a third portion with a depression or a decreasing portion of the projection 362 to contact the backside of the first hook 310 upon even further rotation. This may prevent the rotating element 354 from rotating back to the closed orientation under the bias of the return spring, in particular if a force is applied to the cover 308 in the second direction 152, e.g. an elastic force of the cover 308 itself or a gravitational force. If the cover 308 is removed from the housing, the first hook 310 is no longer in contact with the cam of the rotating element 354 and the rotating element 354 returns to the closed orientation under the bias of the return spring.

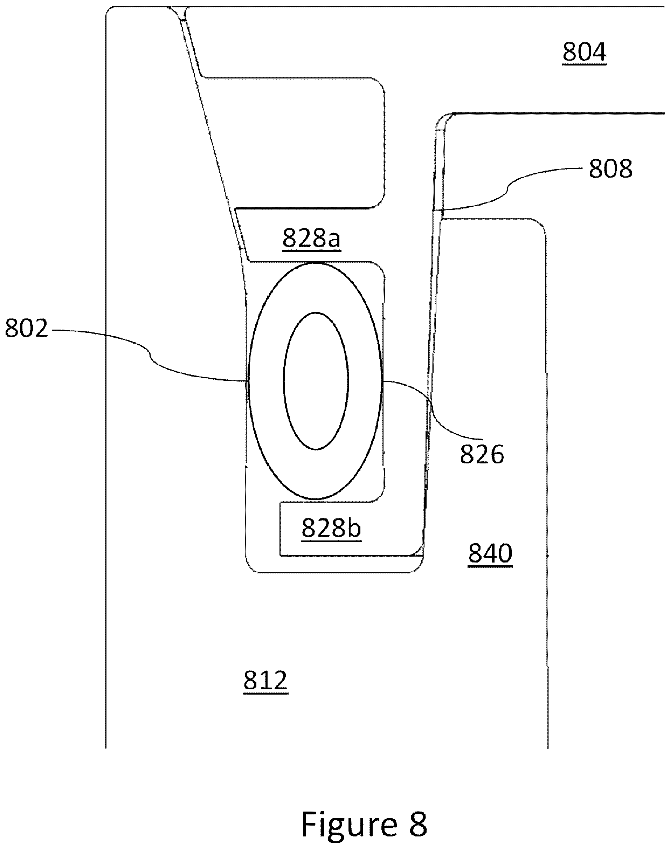

Reference is made to Figure 8, which shows a cross section view simplified illustration of a housing and cover. Housing 812 may be substantially similar to other housings described herein (e.g., housing 112, housing 312, etc.) unless as explicitly described. Cover 804 may be substantially similar to other covers described herein (e.g., cover 104, cover 204, cover 304, etc.) unless as explicitly described. Elements of Figure 8 may have one or more similar characteristics as elements of other figures. For example, the seal 802 of Figure 8 may be similar to and/or include one or more characteristics of the seal 102 of Figure 1 and/or the seal 302 of Figure 3.

The one or more cover guides 840 extend from the inner wall of the housing 812. The one or more cover guides 840 are coupled to the inner wall of the housing 812. The one or more cover guides 840 are configured to fit at least a portion of the seal retention structure 808 and/or the seal 802 therein. The one or more cover guides 840 may be configured to trap at least a portion of the seal retention structure 808 and/or the seal 802 between the one or more cover guides 840 and the wall of the housing 812. At the closed configuration, at least a portion of at least one of the protuberances 828 is located between the wall of the housing 812 and the cover guide 840. At a closed configuration, the seal 802 is located between the wall of the housing 812 and the cover guide 840. At a closed configuration, the seal 802 abuts the wall of the housing 812. At a closed configuration, the seal 802 may alternatively abut the cover guide 840.

In Figure 8, the seal 802 abuts the wall of the housing 812. The seal 802 may alternatively abut the cover guide 840. The seal 802 may also abut both the wall of the housing 812 and the cover guide 840 simultaneously. The wall of the housing 812 may be or include a sealing surface similar to sealing surface 116 of Figure 1.

In the closed configuration, the cover 804 is placed on the housing 812, the cover 804 fills the opening of the housing 812. The sealing surface and the cover guides 840 may be configured to compress the seal 802 and the seal retention structure 808. In the closed configuration, a first hook may engage (e.g., be locked to) a second hook, retaining (e.g., holding) the cover 804 in the opening (e.g., as described with reference to Figure 1). In the open configuration the cover 804 and the housing 812 may be separated. The closed configuration may include engaging the first hook and the second hook thereby retaining (e.g., locking) the housing 812 and the cover 804 in the closed configuration. The rotating element may include a tool recess configured to accept a tool configured to help rotate the rotating element.

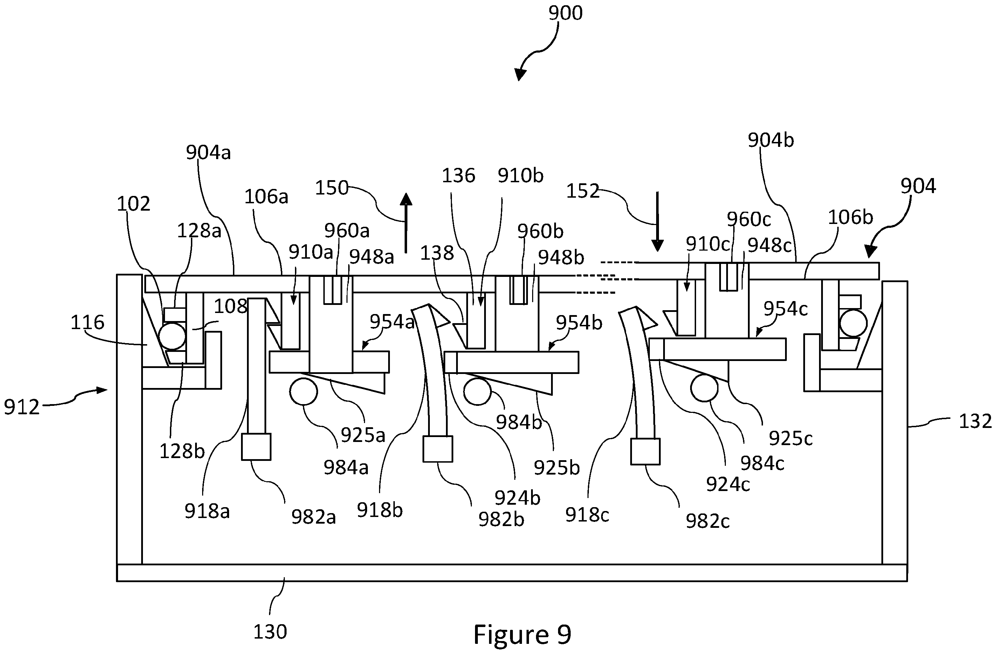

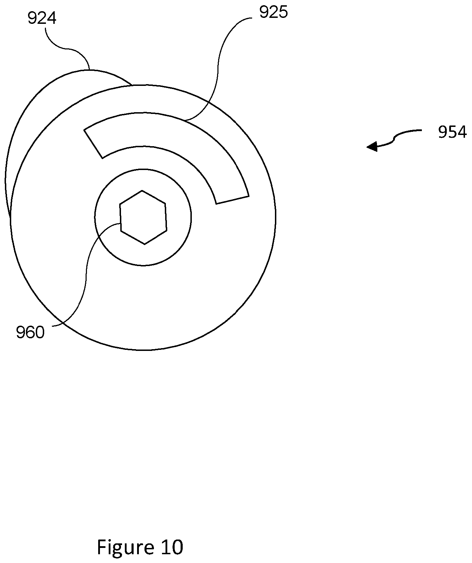

Reference is made to Figure 9, which shows a cross section view schematic illustration of an apparatus 900 comprising a seal 102 and a cover 904. Cover 904 may be substantially similar to other covers described herein (e.g., cover 104, cover 204, cover 304, cover 804, etc.) unless as explicitly described. The cover 904 includes at least one rotating element 954a/954b/954c (collectively referred to as rotating element 954). Rotating element 954 includes a plurality of cams. For example, in Figure 9, the rotating element 954 includes a first cam 924a/924b/924c (collectively referred to as first cam 924) and a second cam 925a/925/b/925c (collectively referred to as second cam 925). An example of the rotating element 954 including a first cam and a second cam is also shown in Figure 10. Rotating element 954 may include a portion 960 (shown in Figure 10) configured to interact with a tool. Portion 960 may include a recess or a protuberance.

Returning to Figure 9, the cover 904 includes at least one first hook 910a/910b/910c (collectively referred to as first hook 910), which may be the same as or similar to first hook 110 of Figure 1, described in detail above. First hook 910 may include a claw 138 as described above.

Apparatus 900 includes a second hook 918a/918b/918c (collectively referred to as second hook 918), which may be similar to at least one second hook 118 of Figure 1, described in detail above. Apparatus 900 includes a hook support 982a/982b/982c (collectively referred to as hook support 982). Hook support 982 may be a member such as a rod or a pin that may extend from a wall of the cover 904 or the housing 912 towards the interior of the enclosure (for example, an interior of the cover or housing). Hook support 982 may include a base portion for the second hook 918. Hook support 982 and the base portion may have any appropriate shape (round, square, etc.). Second hook 918 may be connected to or integrated with hook support 982. A difference between the at least one second hook 118 of Figure 1 and the second hook 918 of Figure 9 is that the at least one second hook 118 of Figure 1 may be attached to or part of rotating element 154, whereas the second hook 918 of Figure 9 may be attached to or part of hook support 982. Second hook 918 may include a claw as described above.

In Figure 9, the first cam 924 is configured to separate the second hook 918 from the first hook 910. The second cam 925 is configured to unseal cover 904 by converting a rotating motion of the rotating element 954 to a linear motion that applies force to the cover 904 from inside the enclosure if the cover 904 is coupled to the housing 912 on first hook 910. Apparatus 900 includes a cam guide 984a/984b/984c (collectively referred to as cam guide 984) configured to guide the second cam 925 if the rotating element 954 is rotated about a rotational axis of the rotating element 954. Cam guide 984 may be a guide member such as, for example, a rod or a pin that extends from a wall of the cover 904 or the housing 912 towards the interior of the enclosure (for example, an interior of the cover 904 or housing 912).

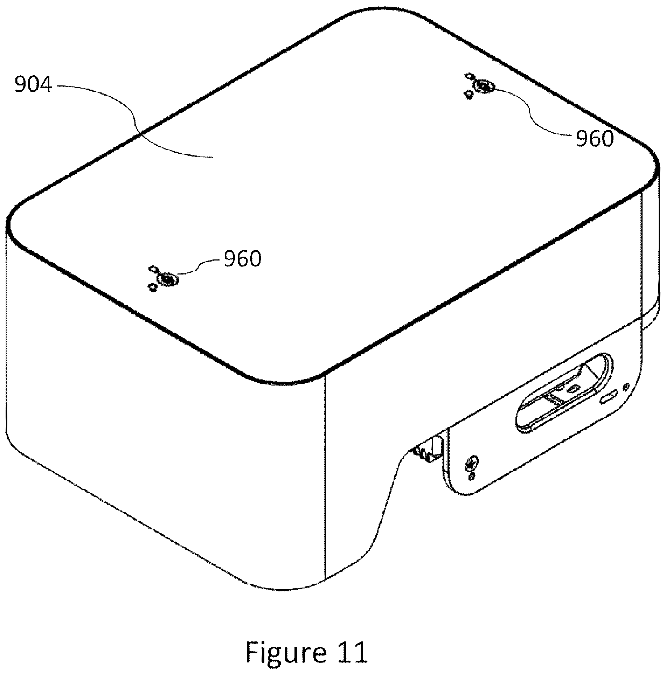

Reference is made to Figure 11, which shows a perspective view schematic illustration of a cover 904. The cover 904 depicted in Figure 11 may include one or more aspects of other covers described herein, and other covers described herein may be similar to and/or include one or more characteristics of the cover 904 of Figure 11. Cover 904 may include a portion 960 of a rotating element 954 with which a tool may be used to interact. In the Figure 11, the portion 960 is located on a top of the cover 904. The portion 960 is located on an exterior portion of cover 904. In some examples, portion 960 may be configured to be rotated without the use of an additional tool. For example, portion 960 may include a protuberance that may be rotated using a hand. In some examples portion 960 may be rotated using a mechanism that is triggered using a wired or wireless signal. Rotating element 954 may include a plurality of cams as shown in Figure 9 and Figure 10.

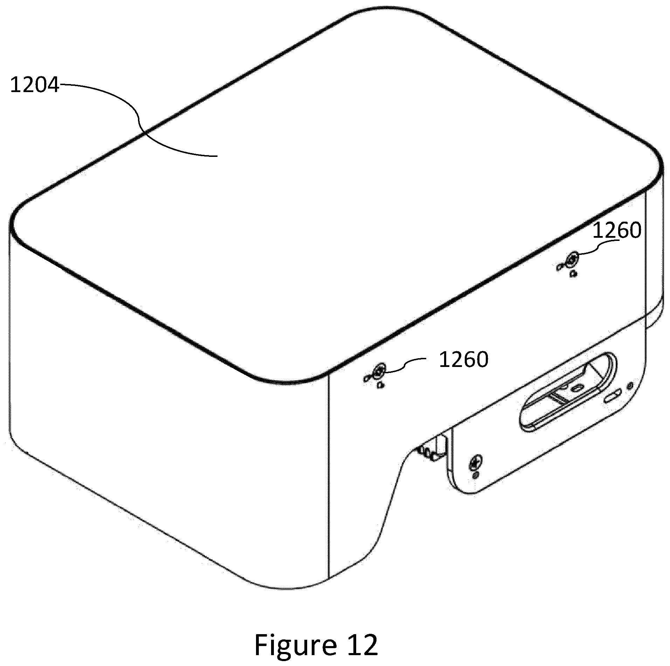

Reference is made to Figure 12, which shows a perspective view schematic illustration of an example cover 1204. Unless as described, the cover 1204 depicted in Figure 12 may include one or more aspects of other covers described herein, and other covers described herein may be similar to and/or include one or more characteristics of the cover 1204 of Figure 12. Cover 1204 may include a portion 1260 of a rotating element that may be interacted with a tool. In Figure 12, the portion 1260 is located on a side of cover 1204. The portion 1260 is located on an exterior portion of cover 1204. In some examples, portion 1260 may be configured to be rotated without the use of an additional tool. For example, portion 1260 may include a protuberance that may be rotated using a hand. In some examples portion 1260 may be rotated using a mechanism that is triggered using a wired or wireless signal. The rotating element may include one or more cams. Cover 1204 may include one or more hooks that interact with one or more hooks on the housing. One or more hooks may be connected to a hook support, wall of the cover, wall of the housing, or connected to a rotating member.

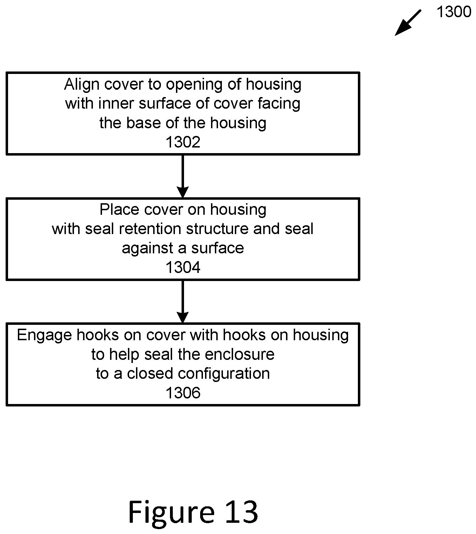

Fig. 13 shows a flowchart of an example method 1300 for sealing a cover to a housing to arrange the apparatus in a closed configuration. Method 1300 may be performed using covers and housings described herein.

In step 1302, the cover is aligned with the housing. The inner surface 106b (shown for example in Figure 1 and Figure 9) may be aligned facing an opening of the housing. For example, the inner surface may be aligned facing the side of the base 130 in the interior of the housing.

In step 1304, the cover is placed on the housing. For example, after aligning the cover with the housing, the cover may be moved, for example, in the second normal direction 152 such that the cover fills the opening of the housing. The cover may be placed on the housing such that a seal engages a surface. For example, if the seal and seal retention structure are on the cover then they may be placed to engage a surface of the housing. For example, the cover may be placed on the housing with the seal retention structure inside a surface of the housing. The surface of the housing may be a sealing surface 116 (shown for example in Figure 1 and Figure 9) and/or cover guides 340 (shown for example in Figure 3 and Figure 4). The surface may include an inclined portion with a changing width between two surfaces such that the seal may be easily placed (e.g., at a greater width between two surfaces) and then engaged (e.g., at a lesser width between the two surfaces) to seal the connection between the cover and the housing. An illustration of a seal 102 engaging a surface 116 is shown with the view of the seal 102 on the left side of Figure 1 and Figure 9. As another example, if the seal and seal retention structure are on the housing then they may be placed to engage a surface of the cover. The surface of the cover may include an inclined portion as described herein.

In step 1306, first hooks on the cover are engaged with second hooks on the housing to help seal the cover to the housing and arrange the apparatus in a closed configuration. For example, each first hook may engage with a corresponding second hook (or there may be more or less first hooks than second hooks). For example, the first hook 110a of the cover may engage the second hook 118a of the rotating element 154a (as shown in Figure 1). As another example, the first hook 910a of the cover may engage the second hook 918a (as shown in Figure 9). In some examples, step 1304 and step 1306 may be substantially simultaneous. In some examples, the closed configuration may include the seal forming a sealed connection between the cover and the housing. Such a sealed connection may couple the cover and the housing and form a sealed enclosure. In some examples, the closed configuration may include a plurality of hooks of the cover being engaged with a plurality of hooks of the housing. Preferably, the first and second hooks function as snap-fit connectors that allow the hooks to engage without requiring a tool or other active step.

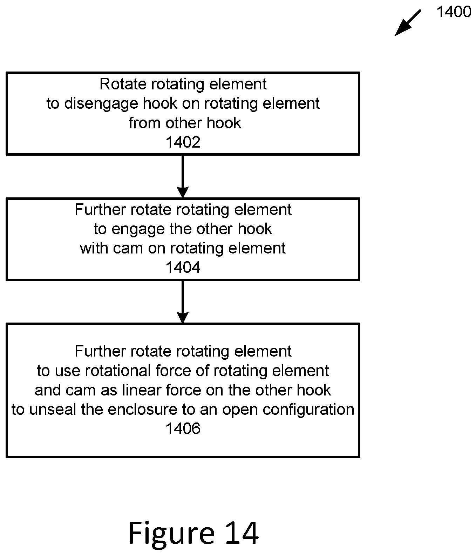

Fig. 14 shows a flowchart of an example method 1400 for unsealing a cover from a housing to arrange the apparatus in an open configuration. Method 1400 may be performed using covers and housings described herein. For example, method 1400 may be performed with a rotating element 154 with a hook 118 and a single cam 124 as shown in Figure 1.

In step 1402, a rotating element is rotated to disengage a first hook from a second hook. For example, the second hook may be connected to or integrally part of the rotating element. The first hook may be connected to or integrally part of the cover and the rotating element may be connected to the housing. For example, each rotating element 154 may be rotated such that second hook 118 disengages from first hook 110. For example, as shown in Figure 1, as rotating element 154b is rotated, second hook 118b disengages from first hook 110b. As another example, the first hook may be connected to or integrally part of the housing and the rotating element may be connected to the cover.

In step 1404, the rotating element is further rotated to engage a hook with a cam. For example, the cam may be connected to or integrally part of the rotating element. The hook may be connected to or integrally part of the cover and the rotating element may be connected to the housing. For example, each rotating element 154 may be further rotated such that cam 124 engages first hook 110. As shown in Figure 1, rotating element 154b may be rotated such that cam 124b engages first hook 110b. As another example, the first hook may be connected to or integrally part of the housing and the rotating element may be connected to the cover. In some examples, step 1402 and step 1404 may be substantially simultaneous.

In step 1406, the rotating element is further rotated to use (e.g., to transfer) rotational force of the rotating element and the cam as a linear force on a hook. The rotating element is further rotated to use the linear force on the hook to unseal the cover from the housing. For example, the linear force may help disengage the seal and/or the seal retention structure from a surface that the seal and/or the seal retention structure is in contact with. The rotating element may be further rotated to use the linear force to open the cover from the housing in an open configuration. For example, the cover may be moved in the first normal direction 150 to separate the cover from the housing. For example, referring to Figure 1, each rotating element 154 may be further rotated such that cam 124 pushes first hook 110 and separates cover 104 from housing 112. As shown in Figure 1, rotating element 154c may be rotated such that cam 124c further engages and pushes first hook 110c. Cam 124c pushing first hook 110c may help disengage, separate, and/or unseal seal 102 from a surface. An illustration of a seal 102 disengaging and being separated from a surface 116 is shown with the view of the seal 102 on the right side of Figure 1. As another example, if the rotating element is on the cover and the hook is on the housing, rotating the rotating member and the cam may move the rotating element and the cover, for example, in the first normal direction 150 to separate the cover from the housing in an open configuration. In some examples, the open configuration may include unsealing the sealed connection between the cover and the housing. Unsealing the sealed connection may de-couple the cover and the housing and unseal the sealed enclosure. In some examples, the open configuration may include a plurality of hooks of the cover and a plurality of hooks of the housing being disengaged.

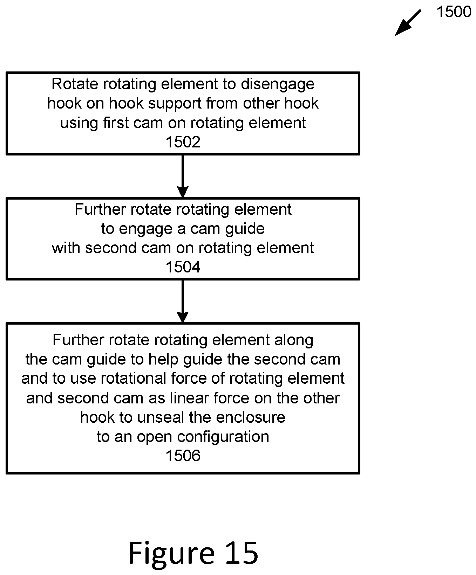

Fig. 15 shows a flowchart of an example method 1500 for unsealing a cover from a housing to arrange the apparatus in an open configuration. Method 1500 may be performed using covers and housings described herein. For example, method 1500 may be performed with a rotating element 154 with a plurality of cams as shown in Figure 9.

In step 1502, a rotating element is rotated to disengage a first hook from a second hook. The first hook may be disengaged from the second hook using a first cam. For example, the first cam may be connected to or integrally part of the rotating element. For example, the second hook may be connected to or integrally part of a hook support. The first hook may be connected to or integrally part of the cover and the hook support may be connected to or integrally part of the housing. For example, referring to Figure 9, each rotating element 954 may be rotated such that first cam 924 engages second hook 918 and displaces at least a portion of second hook 918 such that it disengages second hook 918 from first hook 910. For example, as shown in Figure 9, as rotating element 954b is rotated, first cam 924b may engage second hook 918b and displace a portion of second hook 918 such that second hook 918 disengages from first hook 110b. A portion of second hook 918 may be made with a flexible material. Other portions of second hook 918 may be made with a flexible material or a more rigid material. The rotating element may be connected to the cover, the first hook may be connected to or integrally part of the cover, and the second hook and hook support may be connected to or integrally part of the housing. Alternatively, the rotating element may be connected to the housing, the first hook may be connected to or integrally part of the housing, and the second hook and hook support may be connected to or integrally part of the cover.

In step 1504, the rotating element is further rotated to engage a cam guide with a second cam. For example, the cam guide may be connected to or integrally part of the housing. The second cam may be connected to or integrally part of the rotating element. For example, referring to Figure 9, each rotating element 954 may be further rotated such that second cam 925 engages cam guide 984. As shown in Figure 9, rotating element 954b may be rotated such that second cam 925b engages cam guide 984b. As another example, the cam guide may be connected to or integrally part of the cover. In some examples, step 1502 and step 1504 may be substantially simultaneous.

In step 1506, the rotating element is further rotated to use rotational force of the rotating element and the second cam as a linear force on a hook. The rotating element may be further rotated using the cam guide to help guide the second cam. The rotating element may be further rotated to use the linear force on the hook to unseal the cover from the housing. For example, the linear force may help disengage the seal and/or the seal retention structure from a surface that the seal and/or the seal retention structure is in contact with. The rotating element may be further rotated to use the linear force to displace the cover from the housing and arrange the apparatus in an open configuration. For example, the cover may be moved in the first normal direction 150 to separate the cover from the housing. For example, referring to Figure 9, each rotating element 954 may be further rotated such that second cam 925 further engages and slides along cam guide 984 and pushes first hook 910 and separates cover 904 from housing 912. As shown in Figure 9, rotating element 954c may be rotated such that second cam 925c further engages cam guide 984c and pushes first hook 910c. Second cam 925c pushing first hook 910c may help unseal seal 102 from a surface. An illustration of a seal 102 disengaging and being separated from a surface 116 is shown with the view of the seal 102 on the right side of Figure 9. As another example, if the rotating element is on the housing, rotating the rotating member and the second cam may separate the housing from the cover to arrange the apparatus in an open configuration.

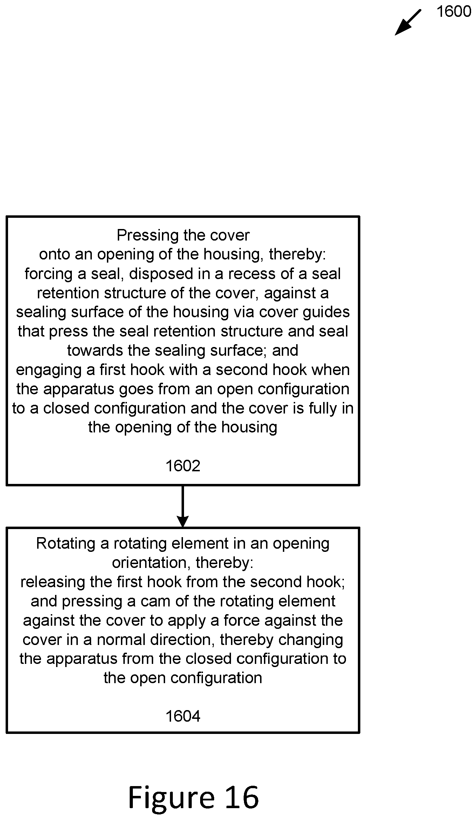

Fig. 16 shows a flowchart of an example method 1600 for sealing a cover to a housing to arrange the apparatus in a closed configuration, and unsealing a cover from a housing to arrange the apparatus in an open configuration. Method 1600 may be performed using covers and housings described herein.

In step 1602, a housing is sealed with a cover by pressing the cover onto an opening of the housing. Pressing the cover onto the opening of the housing may force a seal, disposed in a recess of a seal retention structure of the cover, against a sealing surface of the housing via cover guides that press the seal retention structure and seal towards the sealing surface, and engage a first hook with a second hook based on the apparatus going from an open configuration to a closed configuration and the cover being seated and/or fully in the opening of the housing.

In step 1604, a rotating element is rotated in an opening orientation. Rotating the rotating element in an opening configuration may release the first hook from the second hook, and press a cam of the rotating element against the cover to apply a force against the cover in a normal direction, thereby changing the apparatus from the closed configuration to the open configuration.

Although examples are described above, features and/or steps of those examples may be combined, divided, omitted, rearranged, revised, and/or augmented in any desired manner. Various alterations, modifications, and improvements will readily occur to those skilled in the art. Such alterations, modifications, and improvements are intended to be part of this description, though not expressly stated herein, and are intended to be within the spirit and scope of the disclosure. Accordingly, the foregoing description is by way of example only, and is not limiting.

## Claims

1. An apparatus comprising:
a housing comprising an opening;
at least one seal; and
a cover
wherein the apparatus has a closed configuration and an open configuration, wherein in the closed configuration, the cover fills the opening, and in the open configuration the cover and the housing are separated, wherein the cover may be moved from the closed configuration to the open configuration along a first direction and from the open configuration to the closed configuration along a second direction;
wherein:
at least one seal retention structure is provided on the cover and/or the housing, comprising a seal recess, wherein the seal recess is configured to retain the seal;
at least one sealing surface is provided around an edge of the opening of the housing and/or the cover, wherein the at least one sealing surface is configured to abut at least a portion of the at least one seal, and
wherein the cover comprises a first hook;
the apparatus further comprising:
a second hook configured to engage the first hook thereby limiting motion of the cover in the first direction in the closed configuration;
a rotating element comprising an axis of rotation and a cover lift cam configured to apply a force to the cover in the first direction, based on the rotating element being rotated, causing the cover to separate from the housing.

2. The apparatus of claim 1, wherein the housing further comprises cover guides, wherein in the closed configuration:
the sealing surface and the cover guides are configured to compress the seal and the seal retention structure, in particular to form an ingress protection rated closure, and
the cover guides are configured to constrain a movement of the seal retention structure in a lateral direction.

3. The apparatus of claim 2, wherein the cover guides comprise angled surfaces configured to push the seal retention structure toward the sealing surface based on the apparatus changing from the open configuration to the closed configuration.

4. The apparatus of any of the preceding claims, wherein the rotating element comprises a mechanical element and wherein in the closed configuration the mechanical element is configured to separate the first hook from the second hook based on the rotating element being rotated.

5. The apparatus of any of the preceding claims, wherein the seal recess is configured to apply a first force to the seal substantially opposite the first direction based on a transition from the open configuration to the closed configuration, and wherein the seal recess is configured to apply a second force to the seal in substantially the second direction based on a transition from the closed configuration to the open configuration.

6. The apparatus of any of the preceding claims, wherein the rotating element is configured to rotate in an opening orientation to change the apparatus from the closed configuration to the open configuration, wherein the rotating element comprises a biasing means, in particular a return spring or a cantilever, configured to apply a rotational force to the rotating element, where the rotational force is directed against the opening orientation.

7. The apparatus of any of the preceding claims, wherein the rotating element comprises a tool recess configured to accept a tool, wherein the tool recess comprises a shape that is configured to apply torque to the rotating element based on the tool being rotated.

8. The apparatus of any of the preceding claims, wherein the second hook is incorporated into the rotating element.

9. The apparatus of any of the preceding claims, wherein the second hook comprises a cantilever and is incorporated into the housing, and wherein the rotating element comprises a release cam configured to: apply a second force to the cantilever, deflect the cantilever and release the second hook from the first hook.

10. The apparatus of any of the preceding claims, wherein the rotating element is accessible from a hole in the cover, and wherein the axis of rotation of the rotating element is substantially parallel to the first direction.

11. The apparatus of any of the preceding claims, wherein the rotating element is accessible from a hole in the housing, and wherein the axis of rotation of the rotating element is substantially perpendicular to the first direction.

12. The apparatus of any of the preceding claims, further comprising a second seal recess and a second seal between the rotating element and a hole in the cover or a hole in the housing which preferably form an ingress protection rated closure.

13. The apparatus any of the preceding claims, wherein the rotating element comprises a first part, a second part, and a fastener, and the first part is connected to the second part using the fastener, in particular one or more of a spring clip, a screw, a bolt, a nail, and a rivet.

14. The apparatus of any of the preceding claims, wherein the rotating element further comprises rotation guides.

15. A method for sealing and/or opening a housing, comprising:
for sealing the housing with a cover to form an enclosure:
pressing the cover onto an opening of the housing, and:
forcing a seal, disposed in a recess of a seal retention structure of the cover, against a sealing surface of the housing via cover guides that press the seal retention structure and the seal towards the sealing surface; and
engaging a first hook with a second hook based on the enclosure going from an open configuration to a closed configuration and the cover is seated in the opening of the housing;
and/or
for opening the housing:
rotating a rotating element in an opening orientation, to:
release the first hook from the second hook; and
press a cam of the rotating element against the cover to apply a force against the cover in a first direction, and change the enclosure from the closed configuration to the open configuration.
